# DEMANDE DE BREVET EUROPEEN

(11) **EP 1 407 808 A1**
(43) Date de publication de la demande: **14.04.2004**
(21) Numéro de dépôt: 03103493.7
(22) Date de dépôt: 22.09.2003
(51) Int. Cl.: B01D 67/00, G03F 7/00, B81B 1/00, B01D 69/02, B01D 71/02

(54) **Procédé de fabrication d'une membrane biomimetique, membrane biomimetique et ses applications**

(30) Priorité: 24.09.2002 FR 0211770
(71) Demandeur: COMMISSARIAT A L'ENERGIE ATOMIQUE, 75752 Paris Cédex 15 (FR)
(72) Inventeur: Fuchs, Alexandra, 38120 Saint-Egrève (FR); Heitzmann, Michel, 38920 Crolles (FR); Vinet, Françoise, 38000 Grenoble (FR)
(74) Mandataire: Poulin, Gérard

(57) **Abrégé**

L'invention se rapporte à un procédé de fabrication d'une membrane biomimétique, à une membrane biomimétique et aux applications de cette dernière.

La membrane biomimétique (10) présente un ou plusieurs pores traversants (24) et est caractérisée en ce qu'elle est constituée par au moins deux matériaux micro-usinables différents dont l'un forme la paroi (23) dudit ou desdits pores, tandis que l'autre ou les autres de ces matériaux forment le reste de cette membrane.

Applications : réalisation d'études sur les propriétés dynamiques et fonctionnelles des membranes biologiques ; fabrication de microsystèmes de biocatalyse et de détection ou de dosage de substances.

## Description

### Domaine technique

La présente invention se rapporte à un procédé de fabrication d'une membrane biomimétique, à une membrane biomimétique et aux applications de cette dernière.

Plus précisément, ce procédé permet de fabriquer une membrane poreuse stable, dont la structure mime les caractéristiques structurelles des membranes biologiques et qui présente de plus des zones dotées de propriétés physico-chimiques spécifiques, à l'image des membranes biologiques.

Une telle membrane est susceptible de servir de modèle expérimental dans tous les travaux de recherche portant sur les propriétés dynamiques et fonctionnelles des membranes biologiques, et notamment pour étudier les mécanismes du transport trans-membranaire des molécules et du potentiel de membrane, les processus de diffusion, de réaction et d'interaction aux interfaces biologiques, la dynamique fonctionnelle de protéines membranaires isolées, les réactions d'affinité et de reconnaissance ligands/récepteurs membranaires ou encore la construction d'architectures macromoléculaires sur des interfaces biologiques, ce type d'études intéressant directement les industries de la santé, et en particulier l'industrie pharmaceutique.

Par ailleurs, cette membrane est également susceptible d'être utilisée dans la fabrication de microsystèmes de biocatalyse et de microsystèmes de détection ou de dosage de substances et de servir, en particulier, de couches sensibles dans des biocapteurs.

### Etat de la technique antérieure

Malgré les avancées considérables accomplies ces dernières décennies en biologie cellulaire, les membranes biologiques demeurent un objet majeur d'études tant en ce qui concerne leur constitution que leur fonctionnement.

Les modèles membranaires expérimentaux actuellement utilisés sont, pour la plupart, constitués de bicouches phospholipidiques telles que des bicouches de phosphatidyl choline, phosphatidyl éthanolamine ou phosphatidyl sérine, dans l'épaisseur desquelles sont intégrées des protéines, qui servent de canaux, comme l' λ-hémolysine.

Si ce type de modèles expérimentaux permet d'étudier le mode d'insertion et de fonctionnement des protéines membranaires, en revanche, il n'intègre pas l'une des fonctions capitales des membranes biologiques qui est d'assurer les échanges entre les milieux intra- et extracellulaires.

Par ailleurs, les bicouches lipidiques ont le défaut d'être instables et d'être peu aisées à manipuler. Quant aux protéines jouant le rôle de canaux dans ces bicouches, elles sont labiles et leur diamètre ne peut pas être ajusté.

Il existe donc un intérêt considérable à remplacer les bicouches lipidiques constitutives des membranes biologiques par des interfaces artificielles qui soient capables d'héberger des protéines fonctionnelles et/ou d'offrir des caractéristiques de perméabilité similaires à celles des membranes biologiques.

Les possibilités de miniaturisation offertes par les technologies d'élaboration des microsystèmes électroniques ont amené un certain nombre d'équipes à envisager d'utiliser ces technologies pour réaliser des membranes artificielles. Toutefois, le très faible nombre de publications dans ce domaine témoigne des difficultés que pose la réalisation de telles membranes.

La réalisation la plus avant-gardiste est sans doute, à ce jour, la membrane artificielle réalisée par LI et *al.* (*Nature*, 412, 166-169, 2001 [1]).

Cette membrane est constituée de nitrure de silicium (Si₃N₄) et comporte un seul pore de 1 à 5 nm de diamètre. Elle est réalisée par un procédé qui consiste :
- à déposer une couche de Si₃N₄ sur la face-avant d'un substrat en silicium, par un dépôt chimique en phase vapeur à basse pression (LP-CVP) ;
- à libérer partiellement cette couche par une lithographie et une gravure humide de la face-arrière du substrat ;
- à créer, dans l'épaisseur de la partie de la couche de Si₃N₄ ainsi libérée, une cavité non traversante au moyen d'un faisceau ionique focalisé, le fond de cette cavité se situant du côté de la face-avant de cette couche ;
- à araser la face-avant de ladite couche par l'application d'un faisceau d'ions argon jusqu'à obtenir le percement du fond de la cavité, la percée ainsi réalisée formant un pore d'environ 100 nm de diamètre ; et
- à retoucher partiellement ce pore par le faisceau d'ions argon sous des conditions expérimentales critiques difficilement maîtrisables.

Outre que le procédé développé par ces Auteurs nécessite - comme ils le reconnaissent eux-mêmes - de faire l'objet de nombreuses études complémentaires avant que son utilisation puisse être envisagée à une échelle industrielle, il s'avère qu'il présente l'inconvénient majeur de conduire à la formation d'un pore dont la paroi est nécessairement constituée par le même matériau que celui qui forme le reste de la membrane.

De plus, la boucle de rétrocontrôle qui permet le contrôle du diamètre du pore n'autorise la réalisation que d'un seul pore à la fois.

Or, dans de nombreux domaines, il est indispensable de disposer de membranes artificielles présentant une matrice de pores calibrés dont la paroi soit dotée de fonctionnalités différentes de celles présentées par les portions non-poreuses des faces de ces membranes, ce qui implique que la paroi des pores doit pouvoir être réalisée dans des matériaux différents de ceux utilisés pour réaliser le reste des membranes.

Par ailleurs, la demande Internationale WO 01/36321 [**2**] décrit un procédé de fabrication d'une membrane artificielle comportant une pluralité de nanopores de diamètre inférieur à 50 nm et qui est destinée à être utilisée pour filtrer des substances biologiques.

Ce procédé comprend, dans son mode de mise en oeuvre le plus simple :
- le dépôt, sur la face-avant d'un substrat (par exemple, de silicium), d'une couche sacrificielle d'arrêt de gravure (par exemple, de Si₃N₄), par un dépôt chimique en phase vapeur à basse pression ;
- le dépôt, sur la couche sacrificielle d'arrêt de gravure, d'une couche de structure (par exemple, de silicium polycristallin ou de Si₃N₄) ;
- la formation, dans l'épaisseur de la couche de structure, de trous de largeur de l'ordre du micron, par une gravure de cette couche à l'aide d'un plasma chlore après croissance thermique d'une couche d'oxyde de silicium (SiO₂), ces trous étant destinés à définir la forme des futurs pores de la membrane ;
- la croissance thermique, sur la couche de structure, d'une couche sacrificielle de SiO₂ dont l'épaisseur définit les dimensions nanométriques des pores ;
- la réalisation, dans l'épaisseur de la couche sacrificielle de SiO₂ de points d'ancrage propres à assurer une liaison mécanique entre cette dernière et la couche destinée à la recouvrir à l'étape suivante, ces points d'ancrage étant réalisés par une gravure partielle de ladite couche sacrificielle de SiO₂ en surface et à l'intérieur des pores ;
- le dépôt, sur la couche sacrificielle de SiO₂, d'une couche "bouchon" de silicium polycristallin, dont l'épaisseur est choisie de sorte que le dépôt de cette couche comble les pores (≈ 1,5 µm) ;
- la planarisation de la couche "bouchon" de silicium polycristallin jusqu'à ce qu'il ne reste du silicium polycristallin que dans les pores ;
- le polissage du résidu de la couche "bouchon" de silicium polycristallin ;
- le dépôt, sur chaque face de l'édifice ainsi construit, d'une couche protectrice (par exemple, de Si₃N₄) ;
- l'élimination d'une partie de la couche protectrice située sur la face-arrière du substrat, puis l'élimination du substrat ainsi mis à nu et de la couche d'arrêt de gravure, par une gravure chimique (KOH) ; et
- l'élimination de la couche sacrificielle d'arrêt de gravure et de la couche sacrificielle de SiO₂, par une gravure chimique (HF ou SF₆) couplée à une gravure par plasma d'oxygène.

Ainsi, dans son mode de mise en oeuvre le plus simple, ce procédé comprend pas moins de onze étapes - ce qui en fait un procédé très coûteux -, et conduit à l'obtention d'une membrane qui est formée par la couche de structure (silicium polycristallin ou Si₃N₄) et dont la paroi des pores qui la traversent, n'est pas homogène puisque cette paroi est partiellement constituée par le matériau de la couche de structure et par le polysilicium de la couche "bouchon".

Si ces caractéristiques ne constituent pas un obstacle à l'utilisation de cette membrane pour la filtration de substances biologiques, elles s'opposent par contre à son emploi en tant que modèle expérimental dans des études relatives aux membranes biologiques.

Les Inventeurs se sont donc fixé pour but de fournir un procédé qui permette de réaliser une membrane artificielle apte à reproduire les caractéristiques structurelles et fonctionnelles des membranes biologiques, tout en étant très simple à mettre en oeuvre de manière à ce que les coûts de fabrication de cette membrane soient les plus faibles possibles.

### Exposé de l'invention

Ce but est atteint par la présente invention qui propose un procédé de fabrication d'une membrane biomimétique, qui est caractérisé en ce qu'il comprend les étapes suivantes :
a) déposer, sur l'une des faces principales d'une plaque A d'un matériau micro-usinable, une couche B comprenant une ou plusieurs strates constituées chacune d'un matériau micro-usinable,
b) ménager un ou plusieurs trous traversants dans l'épaisseur de la couche B, chaque trou ayant une paroi constituée par le ou les matériaux formant la couche B et un fond constitué par le matériau de la plaque A,
c) déposer, sur la couche B, la paroi et le fond de chaque trou, une couche C d'un matériau micro-usinable, qui épouse la paroi et le fond de ce trou,
d) éliminer la couche C de la face sous-jacente de la couche B et, au centre de chaque trou, de la face sous-jacente de la plaque A, tout en laissant subsister un résidu de couche C sur la paroi de ce trou, ce résidu délimitant un pore dont la paroi est constituée par le matériau de la couche C et dont le fond est constitué par le matériau de la plaque A, et
e) libérer au moins une partie de la couche B dans laquelle se trouve un ou des pores formés à l'étape d), par élimination partielle ou totale de la plaque A.

on obtient ainsi une membrane qui est constituée par le ou les matériaux formant la couche B sauf au niveau de la paroi du ou des pores qu'elle comporte, cette paroi étant, en effet, constituée par le matériau de la couche C.

Aussi, selon que l'on choisit de réaliser la couche B en une ou plusieurs strates et d'utiliser des matériaux micro-usinables identiques ou différents pour former cette ou ces strates d'une part, et la couche C d'autre part, il est possible d'obtenir, par le procédé selon l'invention, différents types de membranes poreuses, et en particulier :
- des membranes dans lesquelles la paroi du ou des pores qu'elles comportent, est constituée du même matériau que celui qui forme les portions des deux faces principales de ces membranes qui ne sont pas occupées par cette paroi (par exemple, si la couche B ne comporte qu'une seule strate faite du même matériau que celui utilisé pour réaliser la couche C) ;
- des membranes dans lesquelles la paroi du ou des pores qu'elles comportent, est constituée d'un matériau différent de celui qui forme les portions des deux faces principales de ces membranes qui ne sont pas occupées par cette paroi (par exemple, si la couche B ne comprend qu'une seule strate faite d'un matériau différent de celui utilisé pour réaliser la couche C) ; et
- des membranes dans lesquelles la paroi du ou des pores qu'elles comportent, est constituée d'un matériau différent de ceux qui forment les portions des deux faces principales de ces membranes qui ne sont pas occupées par cette paroi, lesdites portions étant, en effet, elles-mêmes constituées d'un matériau différent d'une face à l'autre desdites membranes (par exemple, si la couche B comporte deux strates faites de deux matériaux différents, non seulement l'un de l'autre mais aussi du matériau utilisé pour former la couche C).

Comme précédemment mentionné, le procédé selon l'invention comprend, en tant que première étape, ou étape a) , le dépôt, sur l'une des faces principales d'une plaque A constituée d'un matériau micro-usinable, d'une couche B comprenant une ou plusieurs strates constituées chacune d'un matériau micro-usinable, lequel peut être identique ou différent d'une strate à l'autre.

Par "matériau micro-usinable", on entend, dans ce qui précède et dans ce qui suit, tout matériau qui se prête aux techniques utilisées dans la fabrication des microstructures et des nanostructures, et en particulier aux techniques de dépôt de couches minces, de lithographie et de gravure.

Un tel matériau peut notamment être du silicium, du silicium polycristallin (ou polysilicium), de la silice, un oxyde comme l'oxyde de silicium ou l'oxyde de titane, un nitrure comme le nitrure de silicium ou le nitrure d'aluminium, un métal comme l'or, le cuivre ou le nickel, un alliage métallique comme un alliage d'aluminium ou un alliage cuivre/nickel, un verre comme un verre borosilicaté ou un verre phosphosilicaté, une céramique comme un carbure de silicium, un polymère comme un polyimide ou encore un sol-gel.

Conformément à l'invention, le dépôt, sur la couche A, de la strate ou des strates formant la couche B peut être effectué par l'une quelconque des techniques utilisées pour l'élaboration de couches minces, pour autant qu'elle soit adaptée aux matériaux choisis pour constituer ladite couche B et la plaque A que cette couche est destinée à recouvrir, ou par une combinaison de ces techniques.

Ainsi, par exemple, ce dépôt peut être réalisé par oxydation thermique, par dépôt chimique en phase vapeur (CVD), par dépôt chimique en phase vapeur à basse pression (LP-CVD), par évaporation thermique, par dépôt électrolytique ou électrochimique, par pulvérisation cathodique ou encore au moyen d'un laser pulsé.

Quel que soit le nombre de strates qu'elle comporte et la technique choisie pour les déposer, la couche B présente une épaisseur qui correspond à l'épaisseur que l'on souhaite donner à la membrane, laquelle est, de préférence, comprise entre 5 nm et 5 µm en fonction de la destination de cette membrane.

Après le dépôt de la couche B, le procédé selon l'invention comprend une étape, ou étape b), qui consiste à ménager un ou plusieurs trous traversants dans l'épaisseur de cette couche. Chaque trou ainsi obtenu a donc une paroi constituée par le ou les matériaux de la couche B et un fond constitué par le matériau de la plaque A.

Le procédé selon l'invention est destiné à fabriquer une membrane présentant, soit un seul pore, soit une pluralité de pores pouvant aller jusqu'à 100 millions de pores par mm² de surface, et typiquement jusqu'à 20 millions de pores par mm² de surface.

Aussi, le nombre de trous traversants ménagés dans l'épaisseur de la couche B est compris entre 1 seul trou (pour toute la surface de cette couche) et 100 millions de trous par mm² de surface de la couche B et, de préférence, entre 1 seul trou et 20 millions de trous par mm² de surface de la couche B.

Eu égard à ce qui précède et par souci de simplification rédactionnelle, il est considéré, dans la suite de cet exposé, que la couche B et la membrane comportent respectivement "des" trous et "des" pores et non, un seul trou ou un seul pore.

De préférence, les trous ménagés dans la couche B sont sensiblement cylindriques et sont réalisés par une lithographie, par exemple du type DUV ou à faisceau d'électrons, suivie d'une gravure.

Bien que cette gravure puisse être effectuée aussi bien par voie humide que par voie sèche, on préfère toutefois recourir à une gravure sèche dans la mesure où celle-ci permet, d'une part, d'obtenir des trous de plus faible section que ceux qui seraient obtenus par gravure humide et, d'autre part, de mieux contrôler la section de ces trous - laquelle est de préférence comprise entre 10 nm et 1 µm dans le cas de trous cylindriques - ainsi que leur verticalité.

La troisième étape du procédé selon l'invention, ou étape c), consiste à déposer, sur la couche B, la paroi et le fond des trous, une couche C d'un matériau micro-usinable, qui épouse la paroi et le fond de ces trous, et dont la face opposée à celle située au contact de la couche B, de la paroi et du fond des trous, délimite en conséquence une dépression en forme de U à l'intérieur desdits trous.

Il convient que l'épaisseur de la couche C soit sensiblement constante et qu'elle soit inférieure à la moitié de la plus petite dimension présentée par la section des trous et au plus égale à l'épaisseur de la couche B. Ainsi, dans le cas de trous sensiblement cylindriques, l'épaisseur de la couche C doit être inférieure à leur rayon.

Là également, le dépôt de la couche C peut être effectué par l'une quelconque des techniques utilisées pour l'élaboration de couches minces, pour autant qu'elle soit adaptée aux matériaux choisis pour former cette couche et la couche sous-jacente B.

Une fois la couche C déposée, le procédé selon l'invention prévoit, dans une étape d), d'éliminer cette couche de la face sous-jacente de la couche B et, au centre des trous, de la face sous-jacente de la couche A, tout en conservant un résidu de couche C sur la paroi des trous, de sorte que chaque résidu délimite un pore dont la paroi est constituée par le matériau de la couche C et dont le fond est constitué par le matériau de la plaque A.

Ceci peut être obtenu par une gravure anisotrope de la couche C, c'est-à-dire par une gravure sèche, que l'on effectue perpendiculairement au plan principal de cette couche et qui permet d'éviter l'érosion des parties de cette couche qui recouvrent la paroi des trous.

Il en résulte la formation, dans chaque trou, d'un résidu de couche C ou "espaceur" qui recouvre la totalité de la paroi de ce trou, et qui délimite une ouverture, cette ouverture correspondant à un pore de la membrane en cours de fabrication.

Ainsi, les étapes c) et d) du procédé selon l'invention permettent d'ajuster, en la réduisant, la section des trous ménagés dans la couche B au cours de l'étape b), à celle devant être présentée par les pores de la membrane que l'on souhaite fabriquer.

De plus, en choisissant pour la couche C un matériau différent de celui ou de ceux qui constituent la couche B, les étapes c) et d) permettent de conférer à la membrane des pores dont la paroi est chimiquement différente du reste de cette membrane.

Il est ainsi possible, en utilisant pour former l'une ou l'autre des couches B et C, un matériau de nature hydrophile comme la silice, et pour l'autre de ces couches, un matériau de nature hydrophobe comme le silicium, et en fonctionnalisant éventuellement ces matériaux différemment, par exemple par greffage de composés chimiques ou biochimiques, de fabriquer une membrane dotée à la fois de sites à caractère hydrophobe et de sites à caractère hydrophile et présentant des densités de charges ioniques différentes.

Conformément à l'invention, la gravure anisotrope de la couche C est de préférence une gravure ionique réactive, laquelle peut être réalisée au moyen d'un équipement du type RIE (Reactive Ion Etching), MRIE (Magnetically Enhanced RIE), TCP (Transformer Coupled Plasma), ICP (Inductivally Coupled Plasma), DPS, ECR, DECR ou analogue.

Le procédé selon l'invention comprend ensuite une étape, ou étape e), qui consiste à libérer au moins une partie de la couche B dans laquelle se trouvent des pores formés à l'étape précédente, par élimination partielle ou totale de la plaque A.

Dans un premier mode de mise en oeuvre préféré du procédé selon l'invention, l'étape e) comprend l'élimination totale de la plaque A de sorte que la couche B en est entièrement libérée.

On obtient ainsi une membrane qui se présente sous la forme d'une feuille, laquelle peut être de forme circulaire, parallélépipédique ou autre. Une telle membrane est notamment susceptible d'entrer dans la constitution de microsystèmes de détection et de substances, et en particulier de servir de couches minces dans des biocapteurs.

Dans un autre mode de mise en oeuvre préféré du procédé selon l'invention, l'étape e). comprend les étapes suivantes :
e₁) fixer, sur la face libre de la couche B, une plaque A' d'un matériau micro-usinable, et
e₂) évider les plaques A et A' de manière à libérer la partie de la couche B dans laquelle se trouvent des pores, tout en laissant subsister les chants desdites plaqués ainsi qu'une partie de leur face opposée à celle située au contact de ladite couche B.

On obtient ainsi une membrane qui est solidaire de deux chambres, qui sont disposées de part et d'autre de cette membrane et qui sont munies d'une ouverture en sorte que l'intérieur de ces chambres est accessible.

Ces chambres pourront notamment être remplies de solutions ou de gels polymériques ou non, mimant les milieux intra- et extracellulaires de manière à placer la membrane dans des conditions comparables aux conditions physiologiques, ou pourront être utilisées comme chambres réactionnelles.

Une telle membrane est donc particulièrement bien adaptée à la réalisation d'études sur les membranes biologiques, et notamment sur les processus de diffusion, de réaction et d'interaction aux interfaces ou sur la dynamique fonctionnelle des protéines membranaires.

De préférence, les plaques A et A' sont constituées par le même matériau et sont recouvertes, sur leur face principale opposée à celle située au contact de la couche B, d'une couche D d'un matériau micro-usinable.

Dans ces conditions, l'étape e₂) du procédé selon l'invention comprend de préférence :
- une lithographie suivie d'une gravure humide ou sèche pour éliminer partiellement les couches D,
- une gravure humide pour évider les plaques A et A' tout en laissant subsister un résidu de ces plaques qui recouvre la couche B, et
- une gravure sèche pour libérer la partie de la couche B dans laquelle se trouvent des pores.

Conformément à l'invention, la couche B comprend, de préférence, une ou deux strates.

Lorsque la couche B comprend une seule strate, alors cette dernière est, préférentiellement, constituée d'un matériau micro-usinable différent de celui constituant la couche C.

Lorsque la couche B comprend deux strates, alors ces dernières sont, préférentiellement, réalisées dans des matériaux différents, à la fois l'un de l'autre mais aussi du matériau constituant la couche C.

Dans tous les cas, les matériaux constituant les plaques A et A', la couche B et la couche C sont, de préférence, choisis parmi le silicium, le silicium polycristallin, la silice, l'oxyde de silicium et le nitrure de silicium.

Dans un mode de mise en oeuvre particulièrement préféré du procédé selon l'invention, celui-ci comprend de plus, postérieurement à l'étape e), une étape de fonctionnalisation de la paroi des pores et/ou des portions des faces principales de la membrane qui ne sont pas occupées par cette paroi.

Au sens de la présente invention, on entend par "fonctionnalisation" d'un matériau, tout traitement qui vise à en modifier les propriétés physico-chimiques ou à lui conférer des propriétés physico-chimiques particulières.

Cette fonctionnalisation, qui est choisie en fonction de la destination de la membrane, peut notamment consister en un prétraitement comme une hydroxylation (par voie chimique ou par plasma d'oxygène), suivi d'une silanisation en phase liquide permettant de rendre la zone traitée hydrophobe ou, au contraire, hydrophile (selon le type de silane utilisé), ou de conférer à cette zone des fonctions chimiques (diols, aldéhydes, ...) aptes à servir ultérieurement pour le greffage de molécules d'intérêt, en particulier de molécules biologiques (polypeptides, protéines, oligonucléotides, fragments d'ADN ou d'ARN, ...).

Il est à noter que tous ces traitements sont connus en eux-mêmes. Ils sont notamment décrits par MARTIN et GROVE dans *Biochemical Microdevices,* 3(2), 97-108, 2001 [**3**].

La fonctionnalisation à base de silanes présente l'avantage de conduire à la formation, sur la zone traitée, de couches monomoléculaires de l'ordre de 2 à 4 nm et, partant, de ne pas modifier significativement l'épaisseur de la membrane.

De préférence, l'étape de fonctionnalisation comprend une fonctionnalisation de la paroi des pores et une fonctionnalisation des portions des faces principales de la membrane qui ne sont pas occupées par cette paroi, ces fonctionnalisations étant différentes.

Une telle fonctionnalisation différentielle permet une modulation avantageuse des environnements physico-chimiques à l'interface, propre à renforcer encore le caractère biomimétique de cette membrane. En effet, il est ainsi possible d'aménager localement des zones ayant des propriétés physico-chimiques spécifiques tout en conservant une homogénéité d'ensemble (épaisseur, diamètre des pores, structure chimique globale).

Elle offre, de plus, la possibilité d'incorporer des protéines membranaires dans les pores de la membrane, notamment par la technique de LANGMUIR-BLODGETT - qui permet de préparer, avec un contrôle rigoureux de l'épaisseur et de l'organisation moléculaire, des empilements lipidiques de type lamellaire, par transfert sur support solide d'un film monomoléculaire formé à l'interface air-eau - en jouant sur une fonctionnalisation plus hydrophile de la paroi des pores, propre à retenir la partie hydrophile des zones extramembranaires des protéines.

Il est ainsi possible de déposer, sur chacune des faces de la membrane, une bicouche lipidique qui tapisse cette face et la paroi des pores et de réaliser, en choisissant convenablement les molécules amphiphiles utilisées pour l'élaboration des couches de LANGMUIR-BLODGETT, une incorporation maîtrisée et orientée de protéines de sorte que celles-ci se trouvent dans un environnement lipidique associé à une structure dont les caractéristiques d'épaisseur et de porosité sont similaires à celles d'une membrane biologique.

L'invention a aussi pour objet une membrane biomimétique, qui présente un ou plusieurs pores traversants et qui est caractérisée en ce qu'elle est constituée d'au moins deux matériaux micro-usinables différents dont l'un forme la paroi dudit ou desdits pores, tandis que l'autre ou les autres de ces matériaux forment le reste de cette membrane.

Selon une première disposition avantageuse de la membrane, celle-ci présente une surface comprise entre environ 1 µm² et 1 cm² et une épaisseur comprise entre environ 5 nm et 5 µm.

Selon une autre disposition avantageuse de la membrane, celle-ci présente 1 seul pore ou une pluralité de pores pouvant aller jusqu'à 100 millions de pores par mm² de surface et, de préférence, de 1 pore à 20 millions de pores par mm² de surface.

Selon encore une autre disposition avantageuse de la membrane, le ou les pores de la membrane sont sensiblement cylindriques et présentent un diamètre compris entre 5 et 500 nm.

De préférence, la membrane est constituée de deux ou de trois matériaux micro-usinables différents.

Lorsque la membrane est constituée de deux matériaux micro-usinables, alors l'un forme la paroi du ou des pores qu'elle comporte, tandis que l'autre forme tout le reste de cette membrane.

Lorsque la membrane est constituée de trois matériaux micro-usinables, alors, de préférence, l'un forme la paroi du ou des pores qu'elle comporte, un autre forme les portions de l'une des faces principales de cette membrane qui ne sont pas occupées par cette paroi, et le dernier forme les portions de l'autre des faces principales de cette membrane qui ne sont pas occupées par ladite paroi.

Dans tous les cas, les matériaux micro-usinables qui constituent la membrane sont, de préférence, choisis parmi le silicium, le silicium polycristallin, la silice, l'oxyde de silicium et le nitrure de silicium.

Selon un mode de réalisation préféré de la membrane, celle-ci est solidaire de deux chambres qui sont disposées de part et d'autre de cette membrane, qui présentent un fond, une paroi latérale et une paroi opposée à ce fond, et dont le fond est constitué par ladite membrane, tandis que leur paroi opposée à ce fond est munie d'une ouverture.

De préférence, la paroi latérale des chambres et la paroi de ces chambres qui est opposée à leur fond sont constituées d'un matériau micro-usinable, lequel est également préférentiellement choisi parmi le silicium, le silicium polycristallin, la silice, l'oxyde de silicium et le nitrure de silicium.

Selon un mode de réalisation particulièrement préféré de la membrane, la paroi du ou des pores qu'elle comporte porte des fonctions chimiques et/ou biochimiques différentes de celles portées par les portions des faces principales de cette membrane qui ne sont pas occupées par cette paroi.

Le procédé selon l'invention présente de nombreux avantages.

En particulier, il permet de réaliser des membranes biomimétiques "sur mesure", c'est-à-dire qui présentent exactement des caractéristiques structurelles et fonctionnelles adaptées à l'usage auquel ces membranes sont destinées, notamment par ce qu'il offre la possibilité :
- de moduler l'épaisseur de cette membrane ainsi que la taille et la densité des pores qu'elle comporte et ce, dans des gammes de dimensions allant du nanomètre au micromètre,
- de moduler également les propriétés physico-chimiques (hydrophilie/hydrophobie, charges ioniques, ...) des matériaux qui constitue la paroi des pores et le reste de la membrane,
- de greffer sur ces matériaux des molécules d'intérêt, et notamment des molécules biologiques (polypeptides, protéines, oligonucléotides, fragments d' ADN ou d'ARN, ...),
- de réaliser des pores de la taille d'une protéine membranaire, aptes à loger une telle protéine, ce qui rend ces membranes particulièrement intéressantes pour réaliser des études sur des protéines isolées,
- de fabriquer des membranes dotées de chambres accessibles, ce qui simplifie considérablement leur utilisation dans la conduite d'études expérimentales.

En plus de tous ces avantages, il présente celui d'être simple à mettre en oeuvre et, partant, économiquement intéressant.

L'invention a, de plus, pour objet l'application d'une membrane telle que précédemment définie à la réalisation d'études sur les propriétés dynamiques et fonctionnelles des membranes biologiques.

L'invention a, en outre, pour objet l'application de cette membrane à la fabrication de microsystèmes de biocatalyse ou de détection ou de dosage de substances.

La possibilité de réaliser la membrane selon l'invention dans de très faibles épaisseurs, notamment dans la gamme allant de quelques nm à quelques dizaines de nanomètres, permet d'augmenter la vitesse de diffusion à travers cette membrane par rapport à celle observée avec une membrane polymérique classique.

Aussi, certaines opérations (dialyse, transport, ...) qui sont réalisées en quelques heures, voire en quelques jours avec une membrane polymérique peuvent être effectuées en quelques secondes avec la membrane selon l'invention.

Outre les dispositions qui précédent, l'invention comprend encore d'autres dispositions qui ressortiront du complément de description qui suit, qui se rapporte à deux exemples de mise en oeuvre du procédé selon l'invention ainsi qu'à un exemple d'une membrane réalisée par ce procédé, et qui est donné à titre illustratif et non limitatif, en référence aux dessins annexés.

### Brève description des dessins

Les figures 1 à 5 illustrent schématiquement, sous forme de coupes transversales, les étapes respectivement a) à e) du procédé selon l'invention, dans un premier mode de mise en oeuvre de ce procédé.

Les figures 6 à 9 illustrent schématiquement, sous forme de coupes transversales, l'étape e) du procédé selon l'invention dans un deuxième mode de mise en oeuvre de ce procédé.

La figure 10 correspond à deux photographies prises au microscope optique, à deux grossissements différents (1000 x et 200 x), d'une membrane telle qu'obtenue à l'issue de l'étape e) du procédé selon l'invention.

### Description détaillée

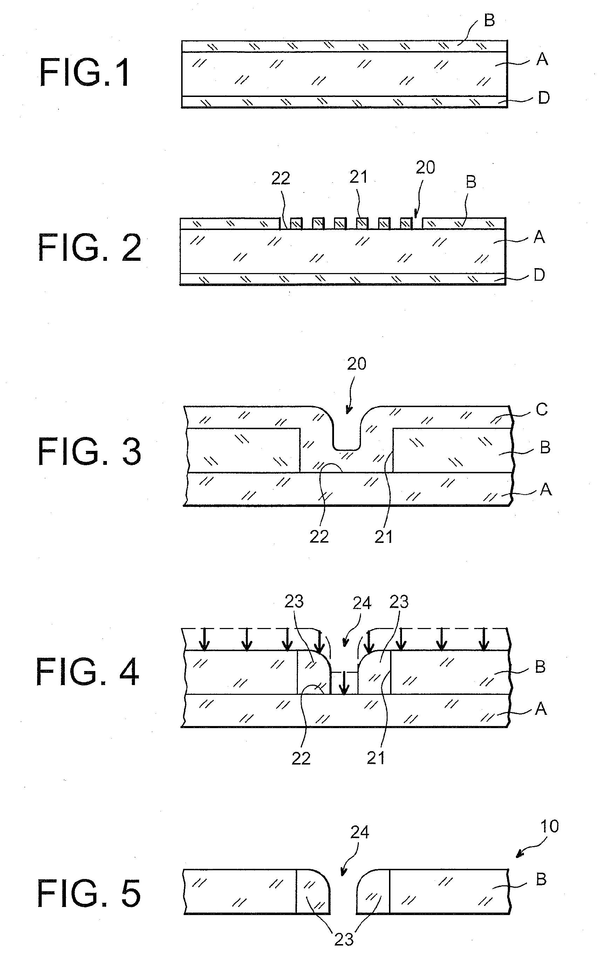

On se réfère tout d'abord aux figures 1 à 4 qui représentent de manière schématique les étapes respectivement a) à e) du procédé selon l'invention dans un premier mode de mise en oeuvre de ce procédé.

Comme visible sur la figure 1, la première étape du procédé ou étape a) comprend le dépôt, sur les deux faces principales d'une plaque A constituée par exemple de silicium, de deux couches, respectivement, B et D, constituées par exemple d'oxyde thermique de silicium.

La deuxième étape du procédé, ou étape b), qui est illustrée sur la figure 2, consiste à ménager dans l'épaisseur de la couche B, par une lithographie suivie d'une gravure sèche de cette couche, par exemple en chimie fluorée ou chlorée, une pluralité de trous 20 qui la traversent de part en part.

La paroi 21 des trous 20 ainsi réalisés est donc constituée par le matériau de la couche B, tandis que leur fond 22 est constitué par le matériau de la plaque A.

L'étape suivante, ou étape c), consiste, comme le montre la figure 3, à déposer, sur la couche B, la paroi 21 et le fond 22 des trous 20, une couche C constituée, soit de SiO₂ comme la couche B, soit d'un autre matériau micro-usinable comme du nitrure de silicium ou du silicium polycristallin.

Cette couche C présente une épaisseur sensiblement constante, qui est inférieure à la moitié de la plus petite dimension de la section des trous 20 ainsi qu'à l'épaisseur de la couche B, de manière à ce que sa face opposée à celle située au contact de la couche B, de la paroi 21 et du fond 22 de ces trous délimite une dépression en forme de U à l'intérieur desdits trous.

Puis, dans l'étape d), qui est illustrée sur la figure 4, on élimine, par une gravure anisotrope (symbolisée par des flèches sur cette figure), la couche C jusqu'à atteindre la face sous-jacente de la couche B et, dans la partie centrale des trous 20, la face sous-jacente de la plaque A. Cette gravure conduit à la formation, dans chaque trou 20, d'un résidu 23 de couche C ou "espaceur", qui recouvre la paroi 21 de ce trou et qui délimite ainsi une ouverture correspondant à un pore 24 de la membrane en cours de fabrication.

Comme visible sur la figure 5, qui montre l'étape e), l'élimination, par une gravure sèche ou humide, de la plaque A permet de libérer la couche B et obtenir ainsi une membrane poreuse 10 qui se présente sous la forme d'une feuille et qui est constituée par le matériau de la couche B sauf au niveau de la paroi des pores 24 qu'elle comporte où elle est constituée par le matériau de la couche C.

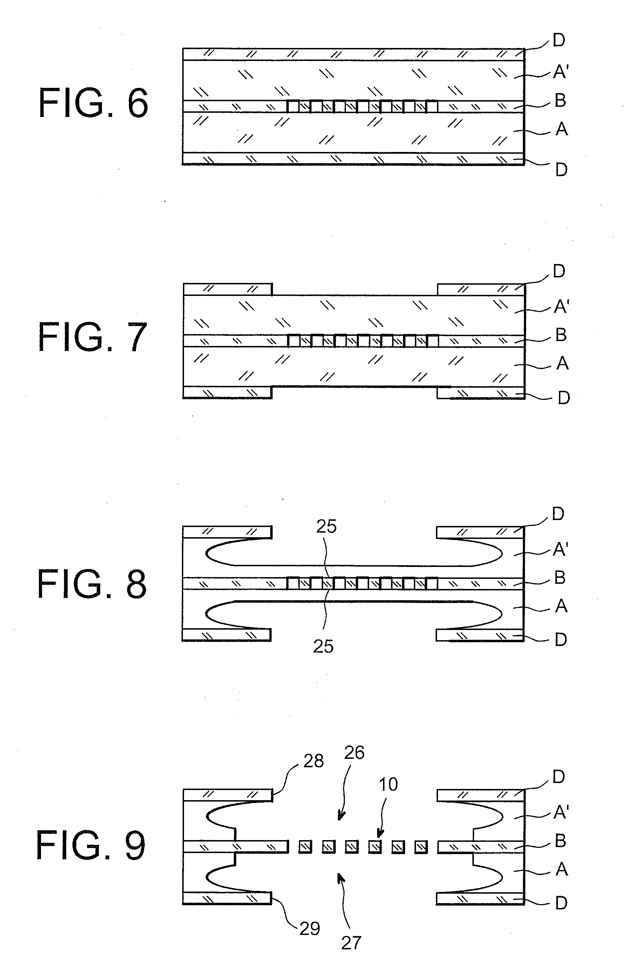

On se réfère à présent. aux figures 6 à 9 qui illustrent schématiquement l'étape e) du procédé selon l'invention dans un deuxième mode de mise en oeuvre de ce procédé permettant de réaliser une membrane dotée de deux chambres accessibles.

Comme visible sur la figure 6, l'étape e) comprend tout d'abord la fixation, par exemple par collage moléculaire, d'une plaque A' sur la face libre de la couche B, cette plaque A' étant recouverte, sur sa face opposée à celle en contact avec la couche B, d'une couche D.

Dans le mode de mise en oeuvre illustré sur la figure 6, la plaque A' et les couches D sont respectivement constituées des mêmes matériaux que ceux qui forment la plaque A et la couche B.

Il peut toutefois en être autrement.

Comme le montre la figure 7, la partie des couches D, qui est située en regard de la partie de la couche B dans laquelle se trouvent les pores 20, est ensuite éliminée par une lithographie suivie d'une gravure humide ou sèche.

Puis, une gravure humide permet d'évider les plaques A et A', tout en conservant un résidu 25 desdites plaques sur chacune des faces de la couche B (figure 8), ce résidu étant secondairement éliminé par une gravure sèche, par exemple au moyen d'un plasma chloré (figure 9 ) .

On obtient ainsi une membrane 10 qui est solidaire de deux chambres, respectivement 26 et 27, qui sont disposées de part et d'autre de cette membrane et qui sont munies d'une ouverture, respectivement 28 et 29, permettant d'accéder à l'intérieur de ces chambres.

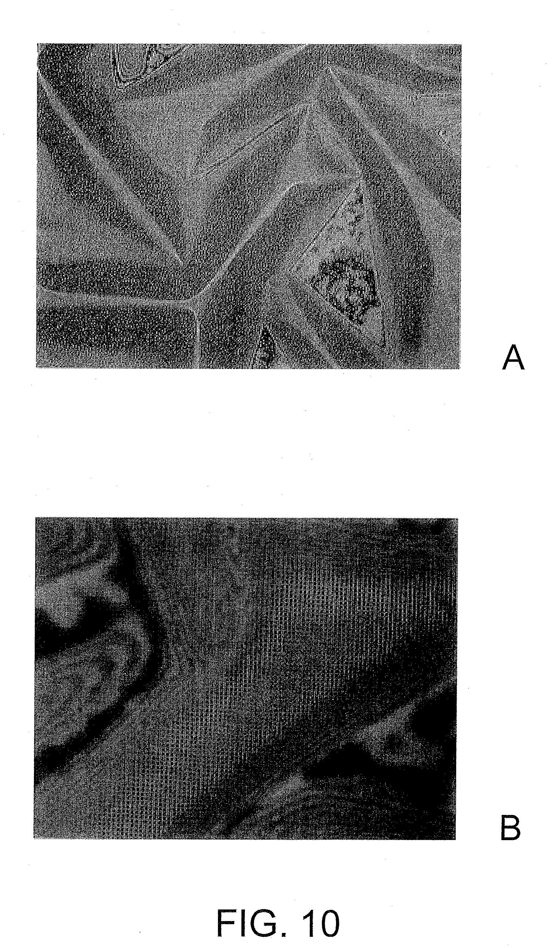

La figure 10 montre deux photographies prises au microscope optique d'une membrane telle qu'obtenue à l'issue de l'étape e) du procédé selon l'invention dans un troisième mode de mise en oeuvre de ce procédé dans lequel la couche B a été partiellement libérée de la plaque A par gravure isotrope sèche de cette dernière au moyen d'un plasma (dans un réacteur de type "downstream" ou "after-glow" et dans une chimie fluorée en présence d'oxygène), cette gravure isotrope ayant été réalisée au travers des pores ménagés dans ladite couche B.

La partie A de la figure 10 correspond à un grossissement de 1000 x, tandis que la partie B de cette figure correspond à un grossissement de 200 x.

Cette membrane présente une surface d'environ 10 mm², une épaisseur de 100 nm et des pores de 350 nm de diamètre distants les uns des autres de 700 nm.

Elle a été réalisée en utilisant une plaque A en silicium et des couches B et C en oxyde de silicium.

La partie A de la figure 10 permet de distinguer la matrice de pores de la membrane, tandis que la partie B de cette figure met en évidence la flexibilité de cette membrane, les portions irisées correspondant à des zones où cette dernière vient se coller à la plaque de silicium sous-jacente.

### Documents cités

[**1**] LI et *al., Nature*, 412, 166-169, 2001
[**2**] WO-A-01/36321
[**3**] MARTIN et GROVE, *Biochemical Microdevices,* 3(2), 97-108, 2001

## Revendications

1. Procédé de fabrication d'une membrane biomimétique (10), **caractérisé en ce qu'**il comprend les étapes suivantes :
a) déposer, sur au moins l'une des faces principales d'une plaque A d'un matériau micro-usinable, une couche B comprenant une ou plusieurs strates constituées chacune d'un matériau micro-usinable,
b) ménager un ou plusieurs trous traversants (20) dans l'épaisseur de la couche B, chaque trou ayant une paroi (21) constituée par le ou les matériaux de la couche B et un fond (22) constitué par le matériau de la plaque A,
c) déposer, sur la couche B, la paroi (21) et le fond (22) de chaque trou, une couche C d'un matériau micro-usinable, qui épouse la paroi et le fond de ce trou,
d) éliminer la couche C de la face sous-jacente de la couche B et, au centre de chaque trou, de la face sous-jacente de la plaque A, tout en laissant subsister un résidu (23) de couche C sur la paroi de ou de ces trous, ce résidu délimitant un pore (24) dont la paroi (25) est constituée par le matériau de la couche C et dont le fond (26) est constitué par le matériau de la plaque A, et
e) libérer au moins la partie de la couche B dans laquelle se trouvent un ou des pores (24) formés à l'étape d), par élimination partielle ou totale de la plaque A.

2. Procédé selon l'une quelconque des revendications précédentes, **caractérisé en ce que** la couche B présente une épaisseur comprise entre environ 5 nm et 5 µm.

3. Procédé selon la revendication 1 ou la revendication 2, **caractérisé en ce que** le nombre de trous traversants (20) ménagés dans l'épaisseur de la couche B, est compris entre 1 seul trou et 100 millions de trous par mm² de surface de la couche B et, de préférence, entre 1 seul trou et 20 millions par mm² de surface de la couche B.

4. Procédé selon l'une quelconque des revendications précédentes, **caractérisé en ce que** le ou les trous traversants (20) ménagés dans la couche B sont sensiblement cylindriques.

5. Procédé selon l'une quelconque des revendications précédentes, **caractérisé en ce que** le ou les trous traversants (20) ménagés dans la couche B sont réalisés par une lithographie suivie d'une gravure, de préférence sèche.

6. Procédé selon l'une quelconque des revendications précédentes, **caractérisé en ce que** l'étape b) comprend une gravure anisotrope de la couche C.

7. Procédé selon la revendication 6, **caractérisé en ce que** la gravure anisotrope de la couche C est une gravure ionique réactive.

8. Procédé selon l'une quelconque des revendications précédentes, **caractérisé en ce que** l'étape e) comprend l'élimination totale de la plaque A.

9. Procédé selon l'une quelconque des revendications 1 à 7, **caractérisé en ce que** l'étape e) comprend les étapes suivantes :
e₁) fixer, sur la face libre de la couche B, une plaque A' d'un matériau micro-usinable, et
e₂) évider les plaques A et A' de manière à libérer la partie de la couche B dans laquelle se trouvent un ou des pores, tout en laissant subsister les chants desdites plaques ainsi qu'une partie de leur face opposée à celle située au contact de ladite couche B.

10. Procédé selon la revendication 9, **caractérisé en ce que** les plaques A et A' sont constituées par le même matériau et sont recouvertes, sur leur face opposée à celle située au contact de la couche B, d'une couche D d'un matériau micro-usinable.

11. Procédé selon la revendication 9 ou la revendication 10, **caractérisé en ce que** l'étape e₂) comprend :
- une lithographie suivie d'une gravure humide ou sèche pour éliminer partiellement les couches D,
- une gravure humide pour évider les plaques A et A' tout en laissant subsister un résidu de ces plaques qui recouvre la couche B, et
- une gravure sèche pour libérer la partie de la couche B dans laquelle se trouvent un ou des pores.

12. Procédé selon l'une quelconque des revendications précédentes, **caractérisé en ce que** la couche B comprend une seule strate et **en ce que** cette strate est constituée d'un matériau micro-usinable différent de celui constituant la couche C.

13. Procédé selon l'une quelconque des revendications 1 à 11, **caractérisé en ce que** la couche B comprend deux strates et **en ce que** ces strates sont constituées de deux matériaux micro-usinables différents l'un de l'autre et différents de celui constituant la couche C.

14. Procédé selon l'une quelconque des revendications précédentes, **caractérisé en ce que** les matériaux micro-usinables constituant les plaques A et A', la couche B et la couche C sont choisis parmi le silicium, le silicium polycristallin, la silice, l'oxyde de silicium et le nitrure de silicium.

15. Procédé selon l'une quelconque des revendications précédentes, **caractérisé en ce qu'**il comprend, après l'étape e), une étape de fonctionnalisation de la paroi du ou des pores (24) et/ou des portions des faces principales de la membrane qui ne sont pas occupées par cette paroi.

16. Procédé selon la revendication 15, **caractérisé en ce que** l'étape de fonctionnalisation comprend une fonctionnalisation de la paroi du ou des pores (24) et une fonctionnalisation des portions des faces principales de la membrane qui ne sont pas occupées par cette paroi, ces fonctionnalisations étant différentes.

17. Membrane biomimétique (10) présentant un ou plusieurs pores traversants (24), **caractérisée en ce qu'**elle est constituée d'au moins deux matériaux micro-usinables différents dont l'un forme la paroi (23) dudit ou desdits pores, tandis que l'autre ou les autres de ces matériaux forment le reste de cette membrane.

18. Membrane biomimétique (10) selon la revendication 17, **caractérisée en ce qu'**elle présente une surface comprise entre environ 1 µm² et 1 cm².

19. Membrane biomimétique (10) selon la revendication 17 ou la revendication 18, **caractérisée en ce qu'**elle présente une épaisseur comprise entre environ 5 nm et 5 µm.

20. Membrane biomimétique (10) selon l'une quelconque des revendications 17 à 19, **caractérisée en ce qu'**elle présente 1 seul pore ou une pluralité de pores pouvant aller jusqu'à 100 millions de pores par mm² de surface et, de préférence, de 1 seul pore à 20 millions de pores par mm² de surface.

21. Membrane biomimétique (10) selon l'une quelconque des revendications 17 à 20, **caractérisée en ce que** le ou les pores (24) qu'elle comporte sont sensiblement cylindriques et présentent un diamètre allant de 5 à 500 nm.

22. Membrane biomimétique (10) selon l'une quelconque des revendications 17 à 21, **caractérisée en ce qu'**elle est constituée de deux ou de trois matériaux micro-usinables différents.

23. Membrane biomimétique (10) selon l'une quelconque des revendications 17 à 22., **caractérisé en ce que** les matériaux qui la constituent, sont choisis parmi le silicium, le silicium polycristallin, la silice, l'oxyde de silicium et le nitrure de silicium.

24. Membrane biomimétique (10) selon l'une quelconque des revendications 17 à 23, **caractérisée en ce qu'**elle est solidaire de deux chambres (26, 27) qui sont disposées de part et d'autre de cette membrane, qui présentent un fond, une paroi latérale et une paroi opposée à ce fond, et dont le fond est constitué par ladite membrane, tandis que leur paroi opposée à ce fond est munie d'une ouverture (28, 29).

25. Membrane biomimétique (10) selon la revendication 24, **caractérisée en ce que** la paroi latérale des chambres (26, 27) et la paroi de ces chambres qui est opposée à leur fond sont constituées d'un matériau micro-usinable.

26. Membrane biomimétique (10) selon la revendication 25, **caractérisée en ce que** ledit matériau micro-usinable est choisi parmi le silicium, le silicium polycristallin, la silice, l'oxyde de silicium et le nitrure de silicium.

27. Membrane biomimétique (10) selon l'une quelconque des revendications 17 à 26, **caractérisée en ce que** la paroi du ou des pores porte des fonctions chimiques et/ou biochimiques différentes de celles portées par les portions de ses faces principales qui ne sont pas occupées par cette paroi.

28. Application d'une membrane biomimétique (10) selon l'une quelconque des revendications 17 à 27 à la réalisation d'études sur les propriétés dynamiques et fonctionnelles des membranes biologiques.

29. Application d'une membrane biomimétique (10) selon l'une quelconque des revendications 17 à 27 à la fabrication de microsystèmes de biocatalyse ou de détection ou de dosage de substances.
